# EUROPEAN PATENT APPLICATION

(11) **EP 1 500 600 A1**
(43) Date of publication of application: **26.01.2005**
(21) Application number: 03717705.2
(22) Date of filing: 23.04.2003
(51) Int. Cl.: B65D 25/14, B65D 65/42, C23C 16/27

(54) **PLASTIC CONTAINERS COATED ON THE INNER SURFACE AND PROCESS FOR PRODUCTION THEREOF**

(30) Priority: 26.04.2002 JP 2002127517; 26.04.2002 JP 2002127425; 28.08.2002 JP 2002249387; 03.09.2002 JP 2002257482
(71) Applicant: Hokkai Can Co., Ltd, Chiyoda-ku, Tokyo 100-0005 (JP)
(72) Inventor: Miyazaki, Shunzo, c/o Technology of Headquarters, Iwatsuki-shi, Saitama 339-0073 (JP); Yamashita, Yuji, c/o Technology of Headquarters, Iwatsuki-shi, Saitama 339-0073 (JP); Nakane, Hiroyuki, c/o Technology of Headquarters, Iwatsuki-shi, Saitama 339-0073 (JP); Shimura, Shouhei, c/o Technology of Headquarters, Iwatsuki-shi, Saitama 339-0073 (JP); Suzuki, Akihisa, c/o Technology of Headquarters, Iwatsuki-shi, Saitama 339-0073 (JP)
(74) Representative: Fenlon, Christine Lesley
(86) International application number: PCT/JP2003/005185
(87) International publication number: WO 2003/091121

(57) **Abstract**

The invention provides a plastic container with a coated inner surface having superior gas barrier properties. It further provides a plastic container with a coated inner surface capable of suppressing elution of minor components from the resin, in addition to having the superior gas barrier properties. The container has on its inner surface an amorphous carbon film formed by plasma CVD from a starting material containing carbon atoms and whose main component is carbon. In the carbon film, when the number of carbon atoms contained in the film is 100, the ratio of the number of nitrogen atoms is 15 or less, or the ratio of the number of oxygen atoms is 20 or less, or the ratio of the total number of nitrogen atoms and oxygen atoms is 27 or less. Alternatively, when the number of carbon atoms contained in the film is 100, the ratio of the number of nitrogen atoms is 15 or less, the ratio of the number of oxygen atoms is 20 or less, and the ratio of the total number of nitrogen atoms and oxygen atoms is 27 or less. The amorphous carbon film exhibits an oxygen permeability of 20×10⁻⁵ ml/day/cm² or less.

## Description

### TECHICAL FIELD

The present invention relates to a plastic container with a coated inner surface, having its inner surface coated with an amorphous carbon film whose main component is carbon, and the method for manufacturing the same.

### BACKGROUND ART

Heretofore, containers formed of various plastics such as polyethylene terephthalate have been used as containers for holding fluid substances such as beverage, food, aerosol, cosmetics and medicine. Such plastic containers are light in weight compared to metal and glass containers, but have a drawback in that it has inferior gas barrier properties.

Recently, in order to improve gas barrier properties, there has been a proposal to coat an amorphous carbon film whose main component is carbon on the inner surface of the plastic container by plasma CVD method, and it has been put to practical use. For example, the plasma CVD method involves placing the plastic container in a hollow processing chamber, evacuating the processing chamber and the interior of the plastic container and maintaining vacuum, introducing a gaseous starting material such as acetylene from the opening of the plastic container into the interior thereof, applying radiofrequency or microwave voltage so as to generate plasma in the plastic container, and forming the amorphous carbon film on the inner surface of the plastic container.

The plastic container having the amorphous carbon film coated on the inner surface thereof can exhibit superior gas barrier properties by increasing the thickness of the film. However, if the thickness of the film is increased, the adhesiveness of the film to the plastic container is deteriorated and the film cannot follow the deformation of the container, so there is a drawback that the container cannot exhibit sufficient workability.

Further, if the thickness of the amorphous carbon film is increased, there is another drawback that the coloring caused by the film becomes noticeable. The coloring caused by the film may not be preferred by consumers, though it depends on the contents. Moreover, the coloring caused by the film may become an obstacle to collecting and recycling the used plastic container such as a polyethylene terephthalate bottle.

The above problems can be overcome by reducing the thickness of the amorphous carbon film, but this solution causes the deterioration of gas barrier properties.

The present invention aims at providing a plastic container with a coated inner surface and the method for manufacturing the same that solves the above-mentioned problems, by providing an amorphous carbon film coated on the inner surface of the container having a thin film thickness but capable of exhibiting superior gas barrier properties.

### SUMMARY OF THE INVENTION

In order to achieve the above objects, the present inventors have studies in detail the gas barrier properties of an amorphous carbon film to be coated on the inner surface of the plastic container. As a result, it has been discovered that the gas barrier properties of the film depends greatly on the ratio of atoms other than carbon contained in the film, especially the ratio of nitrogen atoms or oxygen atoms.

The present inventors have continued investigation based on this discovery, and found that by setting the ratio of the number of nitrogen atoms or the number of oxygen atoms to the number of carbon atoms contained in the film to fall within a predetermined range, the film can exhibit superior gas barrier properties even with reduced film thickness.

Therefore, according to the present invention, the plastic container with a coated inner surface has an amorphous carbon film formed by plasma CVD from a starting material containing carbon atoms and containing carbon as a main component on the inner surface, wherein the amorphous carbon film characterizes in that when the number of carbon atoms contained in the film is 100, one of the following is fulfilled: a ratio of a number of nitrogen atoms to the number of carbon atoms is 15 or less; a ratio of a number of oxygen atoms to the number of carbon atoms is 20 or less; a ratio of a total number of nitrogen atoms and oxygen atoms to the number of carbon atoms is 27 or less; or the ratio of the number of nitrogen atoms to the number of carbon atoms is 15 or less, the ratio of the number of oxygen atoms to the number of carbon atoms is 20 or less, and the ratio of the total number of nitrogen atoms and oxygen atoms to the number of carbon atoms is 27 or less.

According to the plastic container with a coated inner surface of the present invention, the gas barrier properties of the film can be enhanced by having the ratio of the number of nitrogen atoms or oxygen atoms to the number of carbon atoms contained in the amorphous carbon film fall within the above range. Therefore, according to the present plastic container with a coated inner surface, superior gas barrier properties can be achieved even when the thickness of the amorphous carbon film is reduced.

Moreover, since the amorphous carbon film is thin, it has good adhesiveness to the container, and can follow the deformation of the container being subjected to a deformation process. Accordingly, the plastic container with a coated inner surface of the present invention has excellent workability since the gas barrier properties thereof will not deteriorate through deformation.

Furthermore, the amorphous carbon film has reduced film thickness and little coloring. Accordingly, the plastic container with a coated inner surface of the present invention prevents consumers from avoiding the container regardless of its content, and provides no obstacle to collecting and recycling the used container.

On the other hand, if the ratio of the number of nitrogen atoms or oxygen atoms to the number of carbon atoms contained in the amorphous carbon film exceeds the above range, the oxygen permeability or carbonic acid gas permeability of the film increases, and the container can no longer exhibit sufficient gas barrier properties. As a result, if such container is filled with beverage or other contents and left in room temperature or in a hot-warmer, the practical shelf life becomes short and thus not preferable.

The ratio of the number of nitrogen atoms or oxygen atoms to the number of carbon atoms contained in the amorphous carbon film can be measured by using an electron spectroscopy device for chemical analysis (ESCA).

There is another drawback with respect to the plastic container, in which very small amounts of minor components such as oligomers, low molecular-weight components and polymerization catalysts residing in the resin elute into the contents and affect the flavor etc. of the beverages or foods. Thus, there is a demand for a technique capable of improving the gas barrier properties and simultaneously preventing elution of minor components.

According to the studies performed by the present inventors, the amorphous carbon film containing carbon as its main component is superior in both the gas barrier properties and the function to suppress elution of minor components if the oxygen permeability is as low as possible.

Therefore, the plastic container with a coated inner surface according to the present invention characterizes in that the amorphous carbon film has an oxygen permeability of 20×10⁻⁵ ml/day/cm² or less.

According to the present plastic container with a coated inner surface, the permeability of the amorphous carbon film is 20×10⁻⁵ ml/day/cm² or less, by which the film can be reduced of thickness while exhibiting advantageous gas barrier properties and suppressing elution of minor components into the content. Therefore, the plastic container with a coated inner surface according to the present invention achieves superior adhesiveness and superior workability between the amorphous carbon film and container, so that the film will not detach from the container even when the container deforms or receives impact.

Moreover, since the amorphous carbon film is thin and has small coloring, the present plastic container with a coated inner surface will not be avoided by the consumers regardless of its contents, and will not cause any obstruction when collecting and recycling the used container.

The oxygen permeability of the plastic container with a coated inner surface can be measured using a gas transmission rate measuring device such as an OX-TRAN (trade name) manufactured by MOCON, and based on JIS K 7126. Further, the oxygen permeability of the amorphous carbon film itself can be computed based on the measurement of the oxygen permeability of the plastic container thus measured and the oxygen permeability of a plastic container having no film coated thereon.

According to the present plastic container with a coated inner surface, it is preferable that the amorphous carbon film has a thickness in the range of 0.007 through 0.08 µm (70 through 800 angstrom). If the thickness of the amorphous carbon film is less than 0.007 µm, the coloring by the film is suppressed but the oxygen permeability thereof increases. Further, if the thickness of the amorphous carbon film exceeds 0.08 µm, the oxygen permeability is reduced but the coloring increases, deteriorating recycling efficiency and reducing adhesiveness and workability of the film with respect to the container.

According to the present plastic container with a coated inner surface, the plastic container is formed of a polyester resin, and if it has a body portion having a thickness in the range of 0.2 through 0.5 mm, the amorphous carbon film having the above range of oxygen permeability will exert superior gas barrier properties and will have an effect to suppress elution of minor components.

Furthermore, according to the present plastic container with a coated inner surface, the plastic container preferably has an inner volume of 2000 ml or less, in order to form the amorphous carbon film having the above range of oxygen permeability.

The plastic container with a coated inner surface according to the present invention is manufactured by placing the plastic container in a plasma CVD apparatus, maintaining the interior of the plasma CVD apparatus to a predetermined vacuum degree, feeding a gaseous starting material including carbon atoms into the plastic container, supplying a predetermined energy into the plasma CVD apparatus to generate plasma inside the plastic container to thereby form an amorphous carbon film containing carbon as the main component on the inner surface of the plastic container.

However, according to the above method, the ratio of the number of nitrogen atoms or oxygen atoms to the number of carbon atoms contained in the amorphous carbon filmbeing formed exceeds the above-mentioned range, and thus the film cannot exert sufficient gas barrier properties.

The possible causes of the nitrogen atoms or oxygen atoms contained in the amorphous carbon film include a case where removal of air is insufficient when the plasma CVD apparatus is set to predetermined vacuum degree, a case where airtightness of the plasma CVD apparatus is insufficient and air leak occurs, a case where nitrogen gas is used as the carrier gas of the gaseous starting material and the starting material further includes nitrogen-containing or oxygen-containing compounds such as dimethylformamide whose concentration becomes high, or a case where nitrogen-containing or oxygen-containing components are absorbed to the inner surface of the plastic container.

Moreover, if the removal of air is insufficient during reduction of pressure of the interior of the plastic container placed in the plasma CVD apparatus to a determined vacuum degree, air will mix into the gas components including the starting material fed into the plastic container. In such case, since air contains nitrogen and oxygen, the formed film tends to have deteriorated gas barrier properties due to the existence of oxygen compared to the case where only nitrogen is mixed into the gas components.

Therefore, according to the present invention, the plastic container with a coated inner surface can be manufactured advantageously if the gas components including the starting material fed into the plastic container contains a nitrogen gas whose amount being mixed to the total amount of the gas components is 20 % by volume or less, preferably 15 % by volume or less; or an oxygen gas whose amount being mixed to the total amount of the gas components is 10 % by volume or less, preferably 7 % by volume or less; or an oxygen gas whose amount being mixed to the total amount of the gas components is 10 % by volume or less, and the total amount of nitrogen gas and oxygen gas being mixed is 15 % by volume or less, preferably 10 % by volume or less.

According to the present manufacturing method, the ratio of the number of nitrogen atoms or oxygen atoms to the number of carton atoms contained in the amorphous carbon film can be suppressed to fall within the above-mentioned range by controlling the amount of nitrogen gas or oxygen gas contained in the gas components fed to the plastic container to the above-mentioned range. However, in doing so, once the manufacturing process is started, it is difficult to detect and control the change in the amount of nitrogen-containing compounds or air mixing into the starting material and exceeding the above-mentioned range. As a result, the ratio of the number of nitrogen atoms or oxygen atoms to the number of carbon atoms contained in the amorphous carbon film cannot be suppressed to fall within the predetermined range, and thus it may not be possible to obtain a plastic container having the predetermined gas barrier properties.

Therefore, according to the present manufacturing method, it is preferable to detect an emission intensity of plasma of nitrogen based on an emission spectrum of the plasma generated by the gas components containing the starting material being fed into the plastic container, and controlling a concentration of a nitrogen containing compound or an amount of air being mixed into the gas components.

According to the present manufacturing method, gas components containing the starting material are fed into the plastic container and a predetermined amount of energy is supplied into the plasma CVD apparatus, to thereby generate plasma in the plastic container. Thereafter, the emission spectrum of the plasma is measured to thereby detect the emission intensity of the plasma of the nitrogen component (hereinafter referred to as nitrogen plasma emission intensity). Thus, it is possible to determine based on the nitrogen plasma emission intensity the existence of nitrogen in the gas components and the amount thereof. If the nitrogen plasma emission intensity exceeds a predetermined intensity, it is determined that the nitrogen component contained in the gas components exceeds a predetermined range, and the cause thereof is to be eliminated.

According to the present manufacturing method, the cause is actually eliminated by controlling the concentration of the nitrogen-containing compound or the amount of air being mixed into the gas components fed to the plastic container. As a result, the nitrogen component contained in the gas components can be suppressed to within a predetermined range.

Thus, according to the present manufacturing method, it is possible to prevent plastic containers having deteriorated gas barrier properties from being manufactured when the amount of air or nitrogen-containing compound being mixed into the gas components fed to the plastic container exceeds the predetermined range. As a result, according to the present manufacturing method, process management and quality management can be performed easily, and the yield factor of the product can be improved.

The concentration of the nitrogen-containing compound or the amount of air being mixed into the gas components can be controlled through feedback control, for example, and when a nitrogen plasma emission intensity exceeding the predetermined value is detected, a procedure for suppressing the amount of nitrogen-containing compound being mixed in is carried out so as to assure that the plastic containers to be manufactured subsequently exhibit the predetermined gas barrier properties. However, according to the aforementioned feedback control, the predetermined gas barrier properties cannot be obtained for the plastic container being manufactured at the time the nitrogen plasma emission intensity exceeding the predetermined range was detected.

Therefore, according to the present manufacturing method, when the emission intensity of plasma of nitrogen exceeds a predetermined intensity, the plastic container having the amorphous carbon film coated thereon is eliminated from the manufacturing process. When this process is performed, the plastic container having been manufactured at the time the nitrogen plasma emission intensity exceeded the predetermined range will be removed from the manufacturing process subsequent to forming the film, and thus it becomes possible to prevent plastic containers having deteriorated gas barrier properties from being mixed with the good containers.

According to the present manufacturing method, the nitrogen plasma emission intensity is detected by selectively detecting the emission of a specific wavelength range in the emission spectrum. The amount of nitrogen components contained in the gas components can be computed by preparing in advance a calibration curve regarding the amount of nitrogen component and the intensity of emission of a specific wavelength range, and by comparing the detected nitrogen plasma emission intensity with the calibration curve.

The resins for forming the plastic container with a coated inner surface can include polyester resins such as polyethylene terephthalate, polyolefin resins such as polyethylene and polypropylene, polyamide resins, polyether resins and acrylic resins, which are publicly known. However, if the plastic container with a coated inner surface serves as a beverage bottle, the resin should preferably be polyester resin or polyolefin resin.

According to the amorphous carbon film formed by the present manufacturing method, it is preferable that the film has a thickness in the range of 0.02 through 0.08 µm (200 through 800 angstrom) when the oxygen permeability related to suppressing elution of minor components from the plastic container is not considered. If the thickness of the film is less than 0.02 µm, the coloring by the film can be suppressed, but the gas barrier properties thereof is deteriorated regardless of the components of the film, and thus cannot exert sufficient content keeping quality. Further, if the thickness of the film exceeds 0.08 µm, the gas barrier properties are enhanced, but the coloring becomes deeper deteriorating the recycling efficiency and reducing the adhesiveness and workability of the film with respect to the plastic container.

The coloring by the amorphous carbon film can be represented by a Δb* value computed as a difference between b* values determined by transmitting light perpendicularly with respect to the side wall of the plastic container by a color-difference meter before and after forming the film and comparing them. The b* value is a value indicating the color saturation in the yellow direction in a L*a*b* color specification system (JIS Z 8729) standardized by the International Commission on Illumination (CIE), and in general, the value of Δb* increases as the thickness of the amorphous carbon film increases.

Furthermore, the starting material to be used according to the present manufacturing method can include unsaturated hydrocarbon compounds such as acetylene, ethylene and propylene, saturated hydrocarbon compounds such as methane, ethane and propane, and aromatic hydrocarbon compounds such as benzene, toluene and xylene. The above-listed compounds can be used by itself as the starting material or by mixing two or more compounds, but in order to form a film as a polymeric thin film, it is preferable to use the unsaturated hydrocarbon compound such as acetylene or ethylene by itself.

Therefore, according to the present manufacturing method, the starting material should preferably be substantially composed of acetylene. The starting material substantially composed of acetylene can include unavoidable impurities other than acetylene. Furthermore, according to the present manufacturing method, the starting material can include 60 % by volume or more, preferably 80 % by volume or more of acetylene to the whole starting material. The starting material can contain as other components film modifying agents such as hydrogen, organosilicon compounds and film-forming organic compounds. Further, the starting material can be diluted by rare gases such as argon or helium.

The present manufacturing method preferably comprises the steps of maintaining the interior of the plastic container placed in the plasma CVD apparatus to a vacuum degree of 1 through 50 Pa, feeding the gaseous starting material containing the carbon atoms into the plastic container within the range of 0.1 through 0.8 sccm/cm² with respect to an inner surface area of the plastic container, radiating microwaves with energy within the range of 150 through 600 W into the plasma CVD apparatus, and generating plasma in the plastic container during a period of time within the range of 0.2 through 2.0 seconds, thereby forming the amorphous carbon film on the inner surface of the plastic container.

According to the present manufacturing method, the amorphous carbon film can be formed on the inner surface of the plastic container by placing the plastic container in the plasma CVD apparatus that utilizes microwaves, maintaining the interior of the plasma CVD apparatus to a vacuum degree in the above-mentioned range, feeding the gaseous starting material into the plastic container, and radiating microwaves into the plasma CVD apparatus.

According to the plasma CVD apparatus, in the process of generating plasma from the gaseous starting material and forming the amorphous carbon film, it is necessary to set the interior of the plastic container to a vacuum degree within the range of 1 through 50 Pa, preferably 2 through 30 Pa. If the vacuum degree is less than 1 Pa, it takes too much time to form the film. If the vacuum degree exceeds 50 Pa, the adhesiveness and workability of the formed film with respect to the plastic container is deteriorated.

Next, the feeding amount of the starting material should preferably be within the range of 0.1 to 0.8 sccm/cm² to the surface area of the container. If the feeding amount of the starting material is less than 0.1 sccm/cm², the generation of plasma becomes difficult, the thickness of the amorphous carbon film is reduced and the gas barrier property thereof is deteriorated. On the other hand, if it exceeds 0.8 sccm/cm², the thickness of the film becomes too thick and coloring by the film becomes noticeable.

Moreover, the radiation time of the microwaves should preferably fall within the range of 0.2 through 2.0 seconds. If the radiation time of microwaves is less than 0.2 seconds, the generation of plasma becomes difficult and the thickness of the amorphous carbon film is reduced. On the other hand, if the time exceeds 2.0 seconds, the film becomes too thick and coloring by the film becomes noticeable, thus it is not desirable.

Further, by controlling the feeding amount of starting material and radiation time of microwaves to fall within the above-mentioned range and by adjusting the energy of the microwaves to fall within the range of 150 through 600 W, it is possible to obtain a plastic container with a film having a thickness of 0.02 through 0.08 µm, the Δb* value within the range of 2 through 7, and having superior gas barrier properties.

The energy of the microwaves relates closely with the film structure, the coloring and the gas barrier property, and if the energy is less than 150 W, the ratio of sp² bonds forming a conjugated double bond between the carbon-carbon of the amorphous carbon film increases. As a result, a film having reduced gas barrier properties is formed, and coloring by the film becomes deeper.

Moreover, when the energy of the microwaves exceeds 600 W, the ratio of sp³ bonds forming a single bond of a tetrahedron arrangement between the carbon-carbon of the film increases. As a result, the coloring by the film becomes less noticeable, but the gas barrier property thereof is deteriorated.

The plastic container with the coated inner surface can be a rigid container having self-shape holding property, such as a polyethylene terephthalate container, or can be a container having no self-shape holding property, such as a container formed of soft polyethylene. Examples of a container having no self-shape holding property can include a soft polyethylene container for storing fluid such as transfusion in the field of medicine, and a container storing pure water or drinking water of 0.5 to 20 liter and having its exterior supported by a container board or the like.

According to the present manufacturing method, if the plastic container with the coated inner surface is a container having no self-shape holding property, the interior of the container placed in the plasma CVD apparatus is maintained at high pressure than the exterior thereof. Thereby, it is possible to provide a self-shape holding property to the plastic container, so as to form an amorphous carbon film on the inner surface of the container.

### BRIEF DESCRIPTION OF THE DRAWINGS

FIG. 1 is an explanatory cross-sectional view illustrating one example of an apparatus for manufacturing a plastic container according to the present invention.
FIG. 2 is an explanatory cross-sectional view illustrating another example of an apparatus for manufacturing a plastic container according to the present invention.
FIG. 3 is a graph showing one example of spectrum of plasma generated when the gas components fed into the plastic container are only gaseous starting materials.
FIG. 4 is a graph showing one example of spectrum of plasma generated when the gas components fed into the plastic container contain nitrogen component in addition to the gaseous starting materials.

### BEST MODE FOR CARRYING OUT THE INVENTION

Now, the preferred embodiments of the burner according to the present invention will be explained with reference to the accompanying drawings.

First, a plastic container with a coated inner surface according to a first preferred embodiment of the present invention is a 350 ml polyethylene terephthalate bottle (hereinafter abbreviated as PET bottle) for beverages such as green tea drinks, carbonated drinks, beer etc., and has an amorphous carbon film coated on its inner surface. The amorphous carbon film formed on the PET bottle characterizes in that when the number of carbon atoms contained in the film is 100, the ratio of the number of nitrogen atoms to the number of carbon atoms is 15 or less, or the ratio of the number of oxygen atoms to the number of carbon atoms is 20 or less, or the ratio of the total number of nitrogen atoms and oxygen atoms to the number of carbon atoms is 27 or less.

Further, the amorphous carbon film can be characterized in that when the carbon atoms contained in the film is 100, the ratio of the number of nitrogen atoms to the number of carbon atoms is 15 or less, the ratio of the number of oxygen atoms to the number of carbon atoms is 20 or less, and the ratio of the total number of nitrogen atoms and oxygen atoms to the number of carbon atoms is 27 or less.

The amorphous carbon film has a thickness within a range of 0.02 to 0.08 µm (200 to 800 angstrom), for example.

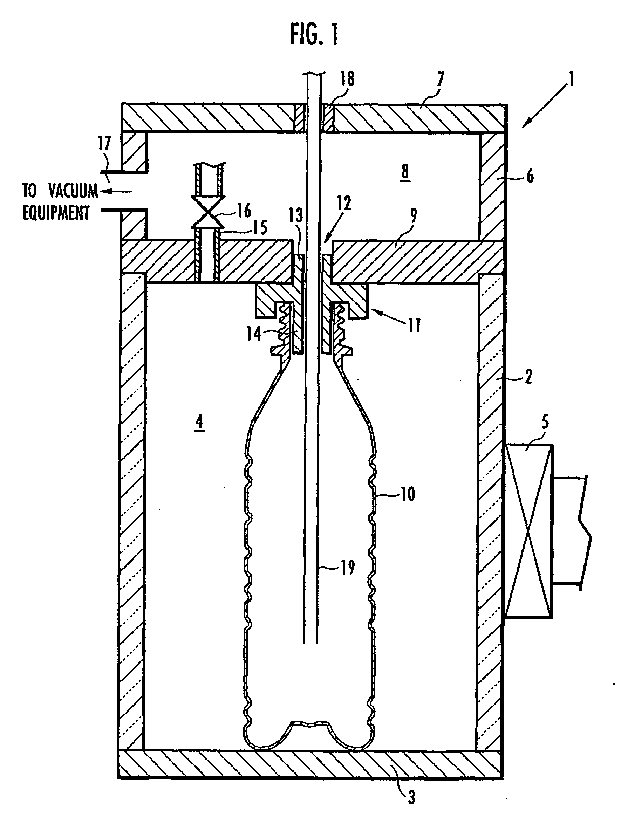

The PET bottle according to the present embodiment can be manufactured using a plasma CVD apparatus illustrated in FIG. 1, for example.

In FIG. 1, a plasma CVD apparatus 1 comprises a processing chamber 4 defined by a side wall 2 formed of Pyrex (registered trademark) glass and a bottom plate 3 movable in the vertical direction, and a microwave generating unit 5 disposed at a position confronting the side wall 2. An evacuation chamber 8 defined by a side wall 6 and an upper wall 7 is equipped to the area above the processing chamber 4, and a partition wall 9 is provided between the processing chamber 4.

The bottom plate 3 allows a PET bottle 10 to be placed thereon and elevates, thereby storing the PET bottle 10 in the processing chamber 4. The PET bottle 10 stored in this manner is placed so that the interior of the container communicates with an evacuation hole 12 formed to the partition wall 9 via an opening portion supporter 11. The opening portion supporter 11 has an upper projection 13 inserted airtightly to the evacuation hole 12, and an opening supporting unit 14 inserted to the opening of the PET bottle 10. There is a gap between the opening supporting unit 14 and the inner surface of the opening of the PET bottle 10 so as to allow the opening supporting unit 14 to be inserted to or removed from the opening, but the inner surface of the opening of the PET bottle 10 is substantially masked by the opening supporting unit 14, so that an amorphous carbon film mentioned in detail later will not be formed on the inner surface of the opening.

The processing chamber 4 and the evacuation chamber 8 are communicated via an air hole 15 with a valve 16 disposed on the partition wall 9, and an opening 17 formed to the side wall 6 of the evacuation chamber 8 is connected to a vacuum equipment not shown. The upper wall 7 of the evacuation chamber 8 supports via a seal 18 a gas inlet tube 19 for feeding a gaseous starting material (hereinafter referred to as material gas) , and the gas inlet tube 19 is passed through the upper wall 7 and the opening portion supporter 11 to be inserted to the PET bottle 10. Further, a gap is formed between the gas inlet tube 19 and the inner circumference wall of the opening portion supporter 11 enabling air to be evacuated from or supplied to the interior of the PET bottle 10.

When manufacturing a PET bottle according to the present embodiment using the plasma CVD apparatus 1 shown in FIG. 1, at first, the bottom plate 3 on which the PET bottle 10 is placed is elevated, storing the PET bottle 10 in the processing chamber 4. Next, the interior of the evacuation chamber 7 is evacuated by the operation of a vacuum equipment not shown, by which the interior of the processing chamber 4 is decompressed via the air hole 15. Simultaneously, the interior of the PET bottle 10 is decompressed to a vacuum degree within the range of 1 to 50 Pa via the gap between the gas inlet tube 19 inserted to the evacuation hole 12 and the inner circumference surface of the opening portion supporter 11.

Next, material gas is fed into the PET bottle 10 through the gas inlet tube 19. In the plasma CVD apparatus 1, material gas is continuously fed while performing evacuation continuously through the vacuum equipment to thereby maintain the interior of the processing chamber 4 and the PET bottle 10 to the above-mentioned vacuum degree. Moreover, the amount of material gas to be fed is set to an appropriate amount corresponding to the surface area of the object PET bottle 10 and the thickness of the film to be formed. The amount of material gas to be fed should appropriately be within the range of 0.1 to 0.8 sccm/cm² per container surface area in order to form a film with a thickness of 0.02 to 0.08 µm to a PET bottle 10 with an inner volume within the range of 200 to 2000 ml.

The material gas can be any of the following: aliphatic unsaturated hydrocarbons such as acetylene and ethylene; aliphatic saturated hydrocarbons such as methane, ethane and propane; aromatic hydrocarbons such as benzene, toluene and xylene; and other carbon-containing compounds. The material gas can be used alone or in a mixture containing two or more gases, and can additionally contain as a film reforming agent a small amount of hydrogen, organosilicon compounds or other organic compounds having film forming properties. The material gas can also be diluted with inert gas such as argon and helium.

However, in order to form a polymeric amorphous carbon thin film having excellent gas barrier properties in a shorter time, it is substantially suitable to use acetylene as the material gas, and it is preferable that the material gas contain 60 % by volume or more acetylene, and more preferably, contain 80 % by volume or more acetylene. If the material gas is substantially formed of acetylene, the acetylene can contain impurities that are unavoidably mixed therein during manufacturing processes and the like.

The material gas is formed so that the amount of nitrogen gas being mixed to the total amount of material gas is 20 % by volume or less, preferably 15 % by volume or less, or the amount of oxygen gas mixed to the total amount of gas is 10 % by volume or less, preferably 7% by volume or less. Alternatively, the material gas can be formed so that the amount of oxygen gas being mixed to the total amount of material gas is 10 % or less, and at the same time, the total amount of nitrogen gas and oxygen gas being mixed is 15 % by volume or less, preferably 10 % by volume or less.

While the material gas is being fed, the microwave generating unit 5 is operated to irradiate microwaves of 2.45 GHz and 150 to 600 W for 0.2 to 2.0 seconds, preferably 0.4 to 1.5 seconds, so as to electromagnetically excite the material gas to generate plasma within the PET bottle 10 and to form an amorphous carbon film (not shown) on the inner surface of the PET bottle. At this time, as mentioned earlier, material gas is continuously fed while performing evacuation through the vacuum equipment to maintain the interior of the processing chamber 4 and the PET bottle 10 to the predetermined vacuum degree, so as to form a stable film. Moreover, if the irradiation time of the microwaves is less than 0.2 seconds, the film may not have the desired thickness, and if it exceeds 2.0 seconds, the film thickness may become excessive and coloring may become deeper.

Next, when the feeding of material gas is terminated, the microwave generating unit 5 is stopped, the interior of the processing chamber 4 and the PET bottle 10 is returned to atmospheric pressure, the bottom plate 3 is lowered and the PET bottle 10 is taken out, by which the process is completed. The microwave generating unit 5 can either be stopped simultaneously when the feeding of the material gas is terminated, but it can be operated in extension for a short time. By this operation, the material gas components residing in the container can be deposited completely as film, according to which the gas barrier properties of the formed PET bottle and the flavor resistance properties when the bottle 10 is filled with contents can be further enhanced.

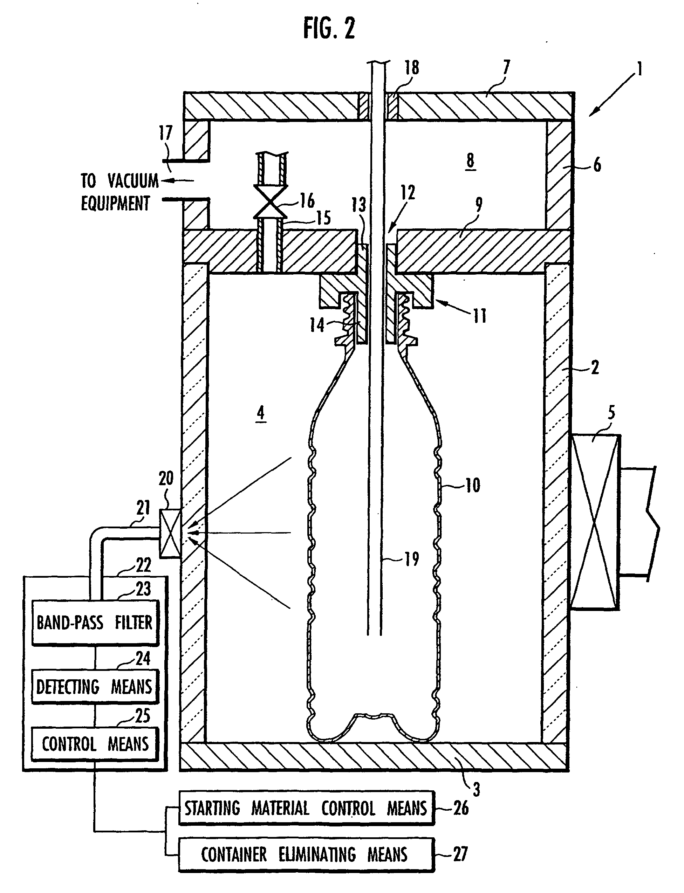

Incidentally, when the PET bottle according to the present embodiment is manufactured as described in the apparatus shown in FIG. 1, once the manufacturing is started, the amount of nitrogen-containing compounds or air being mixed into the material gas may vary and exceed the predetermined range, but it is difficult to detect and control the same. Therefore, the PET bottle according to the present embodiment can be manufactured using a plasma CVD apparatus 1 illustrated in FIG. 2.

The plasma CVD apparatus 1 shown in FIG. 2 comprises, in addition to the components of the plasma CVD apparatus 1 shown in FIG. 1, a light receive unit 20 for receiving the emission of light accompanying the generation of plasma in the plastic container 10. The light receive unit 20 is connected to a plasma emission spectrometry device 22 via an optical fiber 21. The plasma emission spectrometry device 22 is equipped with a band-pass filter 23, a detecting means 24 and a control means 25, and the optical fiber 21 is connected to the band-pass filter 23. The main control means 25 is connected to a gas component control means 26 for controlling the concentration of nitrogen-containing compound or the amount of air mixed into the material gas, and a defective container eliminating means 27 for eliminating the containers 10 that are not equipped with predetermined gas barrier properties as defective containers from the manufacturing process.

The plasma CVD apparatus 1 shown in FIG. 2 is capable of manufacturing the PET bottle according to the present embodiment in the same manner as the plasma CVD apparatus 1 shown in FIG. 1, but when the microwave generating unit 5 is operated to cause plasma to be generated by the gas components fed into the plastic container 10, the apparatus detects the plasma emission intensity of nitrogen included in the plasma emission spectrum.

The nitrogen plasma emission intensity is detected by analyzing the emission spectrum in the plasma emission spectrometry device 22. According to the plasma emission spectrometry device 22, the emission of plasma generated in the plastic container 10 is received by the light receive unit 20 and sent via the optical fiber 21 to the band-pass filter 23.

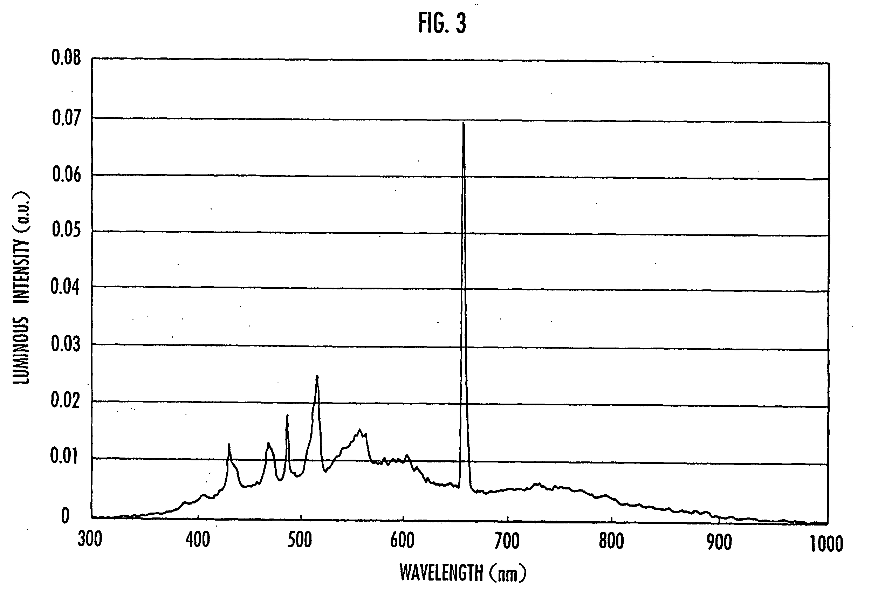

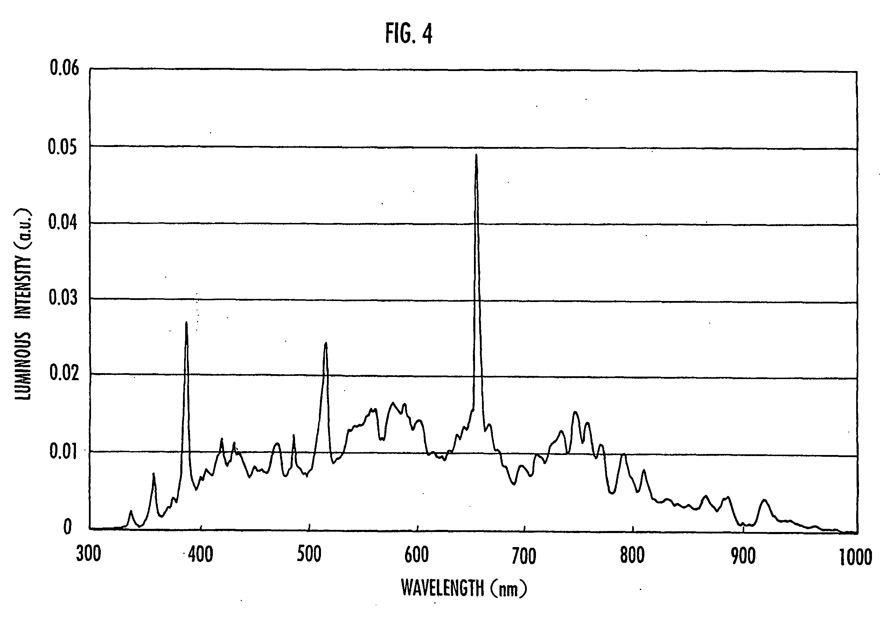

At this time, if the gas components fed into the plastic container 10 contains only material gas, the emission spectrum of plasma will be as shown in FIG. 3. On the other hand, if the gas components fed into the plastic container 10 contain nitrogen components in addition to the material gas, the emission spectrum will be as shown in FIG. 4. According to the spectrum shown in FIG. 4, the radiation within the wavelength region of 700 to 800 nm corresponds to the emission specific to nitrogen plasma, which is considered to be in the region that is relatively hard to overlap with the emission of other components.

Thus, the band-pass filter 23 selectively transmits the radiation in the above-mentioned wavelength region of 700 to 800 nm, and the intensity of the radiation of this wavelength region is detected by the detecting means 24 as the nitrogen plasma emission intensity. Next, the data on the nitrogen plasma emission intensity detected by the detecting means 24 is sent to the main control means 25. The main control means 25 stores in its memory a calibration curve created in advance regarding the amount of nitrogen components contained in the gas components and the intensity of radiation in the above wavelength region, and by comparing the data on the nitrogen plasma emission intensity with the calibration curve, the amount of nitrogen components contained in the gas components can be computed.

When the amount of nitrogen components is detected to exceed 20 % by volume of the total amount of gas components, the main control means 25 adjusts the concentration of nitrogen-containing compound to be mixed into the gas components via the gas component control means 26, thereby controlling the gas components fed into the plastic container 10 to contain 20 % by volume or less of nitrogen gas to the total amount of gas components. Alternatively, the amount of air being mixed into the gas components can be adjusted so that the gas components fed into the plastic container 10 contains 10 % by volume or less of oxygen gas to the total amount of gas components and contains 15 % by volume or less of a total of the nitrogen gas and oxygen gas.

As a result, the subsequent plastic container 10 can have the amount of nitrogen and oxygen contained in the formed film to be controlled within the determined range, and thus it is possible to prevent manufacture of a plastic container 10 with deteriorated gas barrier properties.

Further, when the amount of nitrogen components is detected to exceed 20 % by volume of the total amount of gas components, the main control means 25 eliminates the plastic container 10 taken out of the processing chamber 4 as defective container from the manufacturing processes via the defective container eliminating means 27.

According to the present embodiment, the plasma emission generated in the plastic container 10 is received by the light receive unit 20 and analyzed by the plasma emission spectrometry device 22 equipped with a band-path filter 23, a detecting means 24 and a control means 25, but it is also possible to analyze the same without using the band-path filter 23. Moreover, instead of the light receive unit 20, an optical sensor can be disposed to the position confronting the side wall 2 to analyze the emission.

According further to the present embodiment, the film is coated on the inner surface of the PET bottle for beverages. However, the plastic container of the present invention is not limited to PET bottles for beverages, and can be a container formed of various plastics such as polyester resins, polyolefin resins, polyamide resins, polyether resins or acrylic resins. The above-mentioned resins have various properties corresponding to their molecular structures, but for various uses in which gas barrier properties are required, the present invention can be applied regardless of the type of resins. As for the contents, they are not limited to green tea beverage, carbonated beverage and beer, but can be other beverages such as tea other than green tea, coffee and sparkling liquor, foods such as sauce and soy sauce, or fluid substances such as aerosol, cosmetics and medicine.

Moreover, when the plastic container is formed of a soft rein such as a soft polyethylene resin, the container may have no self-shape holding property in which the container lacks the ability to hold its shape. In this case, when the container is stored in the processing chamber 4 of the plasma CVD apparatus 1 shown in FIG. 1 and the interior of the chamber 4 and the container is decompressed, the exterior of the container can be maintained at higher vacuum than the interior of the container so as to maintain the container shape and to form the film on the inner surface of the container.

Next, the plastic container with a coated inner surface according to a second embodiment of the present invention can be formed for example by blow molding polyester resin, comprising a body portion having a thickness within the range of 0.2 to 0.5 mm and an inner volume of 2000 ml or less. The polyester resin is a resin obtained through condensation polymerization reaction of polyalcohol and polycarboxylic acid compound, through transesterification or the like, and the examples of which can include polyethylene terephthalate resin, polybutylene terephthalate and polyethylenenaphthalate. The plastic container with a coated inner surface according to the present embodiment is used for example as a container for beverages such as tea, coffee, sports drink, carbonatedbeverage, sparkling liquor and beer, container for food such as sauce and soy sauce, an aerosol container or the like.

The plastic container with a coated inner surface according to the present invention is, for example, a PET bottle comprising a body portion with a thickness within the range of 0.2 to 0.5 mm and an inner volume of 350 ml. The PET bottle has on its inner side an amorphous carbon film containing carbon as its main component, and the film has an oxygen permeability of 20×10⁻⁵ ml/day/cm². The PET bottle can be subjected to required treatments, such as heat resistance treatment or the like.

The amorphous carbon film can contain nitrogen, oxygen etc. , and in such case, when the number of carbon atoms contained in the film is 100, the ratio of the number of nitrogen atoms to the number of carbon atoms is 15 or less, or the ratio of the number of oxygen atoms to the number of carbon atoms is 20 or less, or the ratio of the total number of nitrogen atoms and oxygen atoms to the number of carbon atoms is 27 or less. Alternatively according to the present amorphous carbon film, when the number of carbon atoms contained in the film is 100, the ratio of the number of nitrogen atoms to the number of carbon atoms is 15 or less, the ratio of the number of oxygen atoms to the number of carbon atoms is 20 or less, and the ratio of the total number of nitrogen atoms and oxygen atoms to the number of carbon atoms is 27 or less.

If the ratio of the number of nitrogen atoms or the number of oxygen atoms to the number of carbon atoms in the film falls within the above range, the amorphous carbon film has a thickness within the range of 0.007 to 0.08 µm (70 to 800 angstrom), for example. However, if the amorphous carbon film has an oxygen permeability falling within the above range, the thickness thereof can be less than 0.007 µm (70 angstrom).

The PET container can be manufactured by a plasma CVD apparatus 1 illustrated in FIG. 1 or FIG. 2.

The PET bottle 10 according to the present embodiment has superior gas barrier properties because of the amorphous carbon film, and simultaneously, prevents the elution of minor components such as oligomer, low molecular-weight component, polymerization catalyst or the like contained in the resin forming the PET bottle 10. Since little coloring is caused by the amorphous carbon film to the PET bottle 10, the consumers will not avoid the bottle, and the used PET bottle 10 can be recycled without any obstruction.

The present embodiment described an example of a case in which the amorphous carbon film was coated on the inner surface of a PET bottle 10. However, the plastic container according to the present embodiment is not limited to PET bottles, and the container can be formed of other polyester based resins, such as polybutylene terephthalate, polyethylenenaphthalate and so on. At this time, if necessary, the polyester based resins can be mixed with other resins such as allyl resin, phenol resin, polyether resin, epoxy resin, acrylic resin, ethylene copolymerization resin and so on, and the resins can contain an ultraviolet absorber, an ultraviolet screening agent, an antioxidant and so on.

Furthermore, the plastic container according to the present embodiment can be formed of various plastics other than polyester based resins, such as polyolefin based resins, polyamide based resins, polyether based resins, polyacrylic resins and so on.

According to the above-mentioned embodiments, a plasma CVD apparatus using microwaves as means for electromagnetically exciting the material gas was described as an example, but it is also possible to use an apparatus to electromagnetically excite the material gas by applying RF voltage between electrodes arranged on the inner and outer surfaces of the PET bottle 10. However, in order to form an amorphous carbon film having good adhesiveness, workability and superior gas barrier properties, it is appropriate to adopt the plasma CVD apparatus using microwaves.

Next, we will describe the examples and comparative examples.

### [Example 1]

The present example used the plasma CVD apparatus 1 illustrated in FIG. 1 to manufacture a 350 ml PET bottle having its inner surface coated with amorphous carbon film.

At first, according to the present example, the PET bottle 10 was stored in the processing chamber 4 of the plasma CVD apparatus 1 illustrated in FIG. 1, and the processing chamber 4 was decompressed to reduce the pressure inside the PET bottle 10 to a vacuum degree of 10 Pa. Next, a material gas composed of acetylene gas was fed into the PET bottle 10 at a flow rate of 0.4 sccm/cm² with respect to the inner surface area of the PET bottle 10, and microwaves of 2.45 GHz and 380 W was radiated for 0. 6 seconds while maintaining the interior of the PET bottle 10 to the vacuum degree of 10 Pa.

As a result, a PET bottle 10 having an amorphous carbon film with a thickness of 0.04 µm (400 angstrom) coated on the inner surface was obtained.

Next, the PET bottle 10 obtained according to the present example was subjected tomeasurement in an apparatus for electron spectroscopy for chemical analysis (ESCA) to detect the ratio of the number of nitrogen atoms or the number of oxygen atoms to the number of carbon atoms in the amorphous carbon film. As a result, according to the PET bottle 10 obtained by the present example, when the number of carbon atoms contained in the film is 100, the ratio of the number of oxygen atoms was 11 and there were no nitrogen atoms contained.

Next, the oxygen transmission rate of one container per day was measured as an index of the gas barrier property of the PET bottle 10 obtained by the present example. The oxygen transmission rate was measured using an oxygen transmission rate measuring device (manufactured by MOCON, US manufacturer, Trade name: OX-TRAN) at a temperature of 22 °C and humidity of 60 %RH.

As a beverage container, the gas barrier property of the PET bottle 10 should preferably be 0.02 ml/day per bottle or less by oxygen transmission rate, and more preferably, 0.015 ml/day or less. If the oxygen transmission rate per bottle exceeds 0.02 ml/day, the transmission of oxygen may have an adverse effect on the contained object. According to the PET bottle 10 obtained by the present embodiment, the oxygen transmission rate per bottle was 0.003 ml/day.

Next, the degree of coloring caused by the amorphous carbon film of the PET bottle 10 obtained by the present example was evaluated by transmitting light perpendicularly with respect to the side wall of the PET bottle 10 using a color-difference meter to measure the b* value, which is compared with the b* value of the PET bottle 10 before forming the film, so as to compute the Δb* value as the difference between the two values.

The Δb* value should preferably fall within the range of 2 to 7. If the Δb* value is less than 2, the thickness of the amorphous carbon film is too thin to achieve sufficient gas barrier properties, and if the Δb* value exceeds 7, coloring by the film becomes notable. According to the PET bottle 10 obtained by the present example, the Δb* value was 3.

Next, the PET bottles 10 having the amorphous carbon film coated thereon were filled with tea beverage, carbonated beverage and beer, which was kept at room temperature for six months, and then subjected to evaluation of content keeping quality. The result is shown in Table 1, together with the aforementioned film thickness, composition, oxygen transmission rate and Δb* value of the film.

Further, as a reference example, a conventional PET bottle 10 having no amorphous carbon film coated thereon was subjected to evaluation of oxygen transmission rate and content keeping quality under the same conditions as the present example. The results are also shown in Table 1.

Next, the PET bottle 10 having the amorphous carbon film coated thereon was crushed and formed into chips using an extruder to create regenerated polyethylene terephthalate. The chips of the regenerated polyethylene terephthalate resin had very subtle coloring, and can be used to manufacture polyester fibers without any technical problem. As a result, the above chip was confirmed to have an equivalent recycling efficiency as the regenerated polyethylene terephthalate resin formed by crushing the recovered PET bottle 10 of the prior art with no film coated thereon and chipped using an extruder.

### [Example 2]

According to the present example, a 350 ml PET bottle 10 having an amorphous carbon film with a thickness of 0.04 µm (400 angstrom) coated on the inner surface was formed under exactly the same conditions as example 1, except that a mixed gas containing acetylene gas as material gas and air was fed into the PET bottle 10 as gas components. The mixed gas was supplied by feeding the material gas into the PET bottle 10 at a flow rate of 0.4 sccm/cm² with respect to the inner surface area of the PET bottle 10, and feeding air together with the material gas at a flow rate of 0.035 sccm/cm².

At this time, since the ratio of nitrogen to oxygen in the air composition nearly equals 8:2, the oxygen gas in the mixed gas corresponds to 1.6 % by volume to the total amount of gas components fed into the PET bottle 10, and the total amount of nitrogen gas and oxygen gas corresponds to 8 % by volume thereof.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present example in a manner identical to example 1. Further, the degree of coloring caused by the film and the content keeping quality were evaluated in the manner identical to example 1. The results are shown in Table 1.

### [Example 3]

According to the present example, a 350 ml PET bottle 10 having an amorphous carbon film with a thickness of 0.04 µm (400 angstrom) coated on the inner surface was formed under the exact same conditions as example 1, except that a mixed gas containing acetylene gas as material gas and oxygen gas was fed into the PET bottle 10 as gas components. The mixed gas was supplied by feeding the material gas into the PET bottle 10 at a flow rate of 0.4 sccm/cm² with respect to the inner surface area of the PET bottle 10, and feeding oxygen gas together with the material gas at a flow rate of 0.032 sccm/cm².

At this time, the oxygen gas corresponds to 7 % by volume of the total amount of gas components fed into the PET bottle 10.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present example in a manner identical to example 1. Further, the degree of coloring caused by the film and the content keeping quality were evaluated in the manner identical to example 1. The results are shown in Table 1.

### [Example 4]

According to the present example, a 350 ml PET bottle 10 having an amorphous carbon film with a thickness of 0.04 µm (400 angstrom) coated on the inner surface was formed under the exact same conditions as example 1, except that a mixed gas containing acetylene gas as material gas and nitrogen gas was fed into the PET bottle 10 as gas components. The mixed gas was supplied by feeding the material gas into the PET bottle 10 at a flow rate of 0.4 sccm/cm² with respect to the inner surface area of the PET bottle 10, and feeding nitrogen gas together with the material gas at a flow rate of 0.096 sccm/cm².

At this time, the nitrogen gas corresponds to 19 % by volume of the total amount of gas components fed into the PET bottle 10.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present example in a manner identical to example 1. Further, the degree of coloring caused by the film and the content keeping quality were evaluated in the manner identical to example 1. The results are shown in Table 1.

### [Example 5]

According to the present example, a 350 ml PET bottle 10 having an amorphous carbon film with a thickness of 0.04 µm (400 angstrom) coated on the inner surface was formed under the exact same conditions as example 1, except that a mixed gas containing acetylene gas as material gas and air was fed into the PET bottle 10 as gas components. The mixed gas was supplied by feeding the material gas into the PET bottle 10 at a flow rate of 0.4 sccm/cm² with respect to the inner surface area of the PET bottle 10, and feeding air together with the material gas at a flow rate of 0.048 sccm/cm².

At this time, since the ratio of nitrogen to oxygen in the air composition nearly equals 8:2, the oxygen gas in the mixed gas corresponds to 2.2 % by volume of the total amount of gas components fed into the PET bottle 10, and the total of nitrogen gas and oxygen gas corresponds to 11 % by volume thereof.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present example in a manner identical to example 1. Further, the degree of coloring caused by the film and the content keeping quality were evaluated in the manner identical to example 1. The results are shown in Table 1.

### [Comparative Example 1]

According to the present comparative example, a 350 ml PET bottle 10 having an amorphous carbon film with a thickness of 0.04 µm (400 angstrom) coated on the inner surface was formed under the exact same conditions as example 1, except that a mixed gas containing acetylene gas as material gas and oxygen gas was fed into the PET bottle 10 as gas components. The mixed gas was supplied by feeding the material gas into the PET bottle 10 at a flow rate of 0.4 sccm/cm² with respect to the inner surface area of the PET bottle 10, and feeding oxygen gas together with the material gas at a flow rate of 0.052 sccm/cm².

At this time, the oxygen gas corresponds to 12 % by volume of the total amount of gas components fed into the PET bottle 10.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present comparative example in a manner identical to example 1. Further, the degree of coloring caused by the film and the content keeping quality were evaluated in the manner identical to example 1. The results are shown in Table 1.

### [Comparative Example 2]

According to the present comparative example, a 350 ml PET bottle 10 having an amorphous carbon film with a thickness of 0.04 µm (400 angstrom) coated on the inner surface was formed under the exact same conditions as example 1, except that a mixed gas containing acetylene gas as material gas and nitrogen gas was fed into the PET bottle 10 as gas components. The mixed gas was supplied by feeding the material gas into the PET bottle 10 at a flow rate of 0.4 sccm/cm² with respect to the inner surface area of the PET bottle 10, and feeding nitrogen gas together with the material gas at a flow rate of 0.13 sccm/cm².

At this time, the nitrogen gas corresponds to 24 % by volume of the total amount of gas components fed into the PET bottle 10.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present comparative example in a manner identical to example 1. Further, the degree of coloring caused by the film and the content keeping quality were evaluated in the manner identical to example 1. The results are shown in Table 1.

### [Comparative Example 3]

According to the present comparative example, a 350 ml PET bottle 10 having an amorphous carbon film with a thickness of 0.04 µm (400 angstrom) coated on the inner surface was formed under the exact same conditions as example 1, except that a mixed gas containing acetylene gas as material gas and air was fed into the PET bottle 10 as gas components. The mixed gas was supplied by feeding the material gas into the PET bottle 10 at a flow rate of 0.4 sccm/cm² with respect to the inner surface area of the PET bottle 10, and feeding air together with the material gas at a flow rate of 0.096 sccm/cm².

At this time, since the ratio of nitrogen to oxygen in the air composition nearly equals 8:2, the oxygen gas in the mixed gas corresponds to 3.8 % by volume of the total amount of gas components fed into the PET bottle 10, and the total of nitrogen gas and oxygen gas corresponds to 19 % by volume thereof.

Next, the ratio of the number of nitrogen atoms or the number of oxygen atoms to the number of carbon atoms in the amorphous carbon film and the oxygen transmission rate per bottle as an index of gas barrier property were measured for the PET bottle 10 obtained by the present example in a manner identical to example 1. Further, the degree of coloring caused by the film and the content keeping quality were evaluated in the manner identical to example 1. The results are shown in Table 1.

**[Table 1]**

| | | Ref Ex. | Example Example | | | | | Comparative Example | | |
|---|---|---|---|---|---|---|---|---|---|---|
| | | | 1 | 2 | 3 | 4 | 5 | 1 | 2 | 3 |
| Material Gas Flow Rate | Acetylene (sccm/cm²) | - | 0.4 | 0.4 | 0.4 | 0.4 | 0.4 | 0.4 | 0.4 | 0.4 |
| | Air (sccm/cm²) | - | 0 | 0.035 | 0 | 0 | 0.048 | 0 | 0 | 0.096 |
| | Nitrogen (sccm/cm²) | - | 0 | 0 | 0 | 0.096 | 0 | 0 | 0.13 | 0 |
| | Oxygen (sccm/cm²) | - | 0 | 0 | 0.032 | 0 | 0 | 0.052 | 0 | 0 |
| Film Thickness (µm) | | - | 0.04 | 0.04 | 0.04 | 0.04 | 0.04 | 0.04 | 0.04 | 0.04 |
| Ratio of Number Of Atoms | Nitrogen | - | 0 | 6 | 0 | 13 | 7 | 0 | 16 | 13 |
| | Oxygen | - | 11 | 16 | 17 | 12 | 16 | 24 | 13 | 19 |
| | Nitrogen + Oxygen | - | 11 | 22 | 17 | 25 | 23 | 24 | 29 | 32 |
| Oxygen transmission rate (ml/day) | | 0.0 3 | 0.00 3 | 0.011 | 0.014 | 0.011 | 0.013 | 0.025 | 0.01 7 | 0.022 |
| Δb* | | - | 3 | 3 | 3 | 3 | 3 | 3 | 3 | 3 |
| Container Appearance | | ⓞ | ○ | ○ | ○ | ○ | ○ | ○ | ○ | ○ |
| Content Keeping Quality | Green Tea beverage | × | ⓞ | ⓞ | ○ | ⓞ | ○ | Δ | Δ | Δ |
| | Carbonated beverage | × | ⓞ | ⓞ | ○ | ⓞ | ○ | Δ | Δ | Δ |
| | Beer | × | ⓞ | ⓞ | ○ | ⓞ | ○ | Δ | Δ | Δ |

- Ratio of number of atoms:: Ratio of number of atoms of each element
when the number of carbon atoms
contained in the film is 100
"Nitrogen + Oxygen" shows total number
of nitrogen and oxygen atoms
- Container appearance:: ⓞ clear and colorless
○ clear brown (subtle coloring)
Δ clear brown (with coloring)
× clear brown (deep coloring)
- Content keeping quality Green tea beverage:: ⓞ no change in color/flavor
○ change in color/flavor but practically not a problem
Δ change in color/flavor
× defective color/flavor
- Carbonated beverage, Beer:: ⓞ extremely small change in gas volume (8% or less)
○ small change in gas volume
Δ somewhat large change in gas volume
× large change in gas volume (38% or greater)

Based on Table 1, according to the PET bottles 10 of examples 1 through 5 wherein the ratio of the number of nitrogen atoms to the number of carbon atoms is 15 or less, or the ratio of the number of oxygen atoms to the number of carbon atoms is 20 or less, or the ratio of the total number of nitrogen atoms and oxygen atoms to the number of carbon atoms is 27 or less when the number of carbon atoms contained in the film is 100, the oxygen transmission rate per bottle was 0.015 ml/day or less, which clearly has superior gas barrier properties compared to 0.03 ml/day of the PET bottle of the reference example having no film coated thereon.

Further, according to the PET bottle 10 of comparative example 1 wherein the ratio of the number of oxygen atoms to the number of carbon atoms exceeds 20, or that of comparative example 2 wherein the ratio of the number of nitrogen atoms to the number of carbon atoms exceeds 15, or that of comparative example 3 wherein the ratio of the total number of nitrogen atoms and oxygen atoms to the number of carbon atoms exceeds 27 when the number of carbon atoms contained in the film is 100, the oxygen transmission rate per bottle all exceeded 0.015 ml/day. Accordingly, it is clear that the PET bottles 10 of examples 1 through 5 have better gas barrier properties than those of comparative examples 1 through 3.

Further, it is clear that the PET bottles 10 of examples 1 through 5 have better content keeping qualities than that of the PET bottle of the reference example or those of the PET bottles 10 of comparative examples 1 through 3.

### [Example 6]

The present example used the plasma CVD apparatus 1 illustrated in FIG. 1 to manufacture a 350 ml PET bottle having its inner surface coated with amorphous carbon film.

At first, according to the present example, the PET bottle 10 was stored in the processing chamber 4 of the plasma CVD apparatus 1 illustrated in FIG. 1, and the processing chamber 4 was decompressed to reduce the pressure within the PET bottle 10 to a vacuum degree of 10 Pa. Next, a material gas composed of acetylene gas was fed into the PET bottle 10 at a flow rate of 0.4 sccm/cm² with respect to the inner surface area of the PET bottle 10, and microwaves of 2.45 GHz and 380 W was radiated for 0.6 seconds while maintaining the interior of the PET bottle 10 to the vacuum degree of 10 Pa.

As a result, a PET bottle 10 having an amorphous carbon film with a thickness of 0.045 µm (450 angstrom) coated on the inner surface was obtained.

Next, the PET bottle 10 obtained according to the present example was subjected to measurement for measuring the ratio of the number of nitrogen atoms or the number of oxygen atoms to the number of carbon atoms in the amorphous carbon film, the oxygen permeability of the film and the amount of elution of aldehyde. The results are shown in Table 2.

The ratio of the number of nitrogen atoms or the number of oxygen atoms to the number of carbon atoms in the amorphous carbon film was measured using an apparatus for electron spectroscopy for chemical analysis (ESCA).

The oxygen permeability of the amorphous carbon film was shown by a value computed from a measurement of a PET bottle 10 having the amorphous carbon film coating and a measurement of a PET bottle 10 having no amorphous carbon film coating using an oxygen permeability measuring device (manufactured by MOCON, US manufacturer, Trade name: OX-TRAN) at a temperature of 22 °C and humidity of 60 %RH. The value of the oxygen permeability correlates to the oxygen transmission rate of a bottle per day.

The gas barrier property required for the PET bottle 10 to be used as a beverage container is preferably 0.02 ml per bottle per day or less as the oxygen transmission rate, and more preferably, 0.015 ml or less. If the oxygen transmission rate per bottle exceeds 0.02 ml/day, the transmission of oxygen may have an adverse effect on the contained object. The oxygen transmission rate of a bottler per day is shown in Table 2.

Further, the amount of elution of minor components such as oligomer, low molecular-weight components, polymerization catalyst or the like contained in the resin forming the PET bottle 10 manufactured according to the present example was measured using aldehyde, which is a low molecular component specific to polyester resin, as the index. The amount of elution of the aldehyde eluted in the PET bottle 10 when an empty PET bottle 10 having no content was sealed and left for a day was measured using a gaschromatograph, and this value was shown as a relative value to the value measured for a PET bottle 10 having no amorphous carbon film coating, when the value for the PET bottle 10 having no amorphous carbon film coating is taken as 100.

### [Example 7]

According to the present example, a 350 ml PET bottle 10 having an amorphous carbon film with a thickness of 0.045 µm (450 angstrom) coated on the inner surface was formed under the exact same conditions as example 6, except that a mixed gas containing acetylene gas as material gas and a small amount of air was fed into the PET bottle 10 as gas components.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen permeability per bottle per day.

### [Example 8]

According to the present example, a 350 ml PET bottle 10 having an amorphous carbon film with a thickness of 0.045 µm (450 angstrom) coated on the inner surface was formed under the exact same conditions as example 6, except that a mixed gas containing acetylene gas as material gas and a small amount of oxygen gas was used.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

### [Example 9]

According to the present example, a 350 ml PET bottle 10 having an amorphous carbon film with a thickness of 0.045 µm (450 angstrom) coated on the inner surface was formed under the exact same conditions as example 6, except that a mixed gas containing acetylene gas as material gas and a small amount of nitrogen gas was used.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

### [Example 10]

According to the present example, a 350 ml PET bottle 10 having an amorphous carbon film with a thickness of 0.045 µm (450 angstrom) coated on the inner surface was formed under the exact same conditions as example 6, except that the composition ratio of the mixed gas containing acetylene gas as material gas and a small amount of air was changed.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 1. The results are shown in Table 2, together with the oxygen transmission rate per bottle per day.

### [Example 11]

According to the present example, a 350 ml PET bottle 10 having an amorphous carbon film with a thickness of 0.02 µm (200 angstrom) coated on the inner surface was formed under the exact same conditions as example 6, except that the flow rate of material gas containing acetylene gas was suppressed to a low value compared to that of example 6.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

### [Example 12]

According to the present example, a 350 ml PET bottle 10 having an amorphous carbon film with a thickness of 0.012 µm (120 angstrom) coated on the inner surface was formed under the exact same conditions as example 6, except that the flow rate of material gas containing acetylene gas was suppressed to a low value compared to that of example 6.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

### [Example 13]

According to the present example, a 350 ml PET bottle 10 having an amorphous carbon film with a thickness of 0.01 µm (100 angstrom) coated on the inner surface was formed under the exact same conditions as example 6, except that the flow rate of material gas containing acetylene gas was suppressed to a low value compared to that of example 6.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

### [Example 14]

According to the present example, a 350 ml PET bottle 10 having an amorphous carbon film with a thickness of 0.02 µm (200 angstrom) coated on the inner surface was formed under the exact same conditions as example 10, except that a small amount of air was added to the material gas containing acetylene, and that the flow rate thereof was reduced.

Next, the ratio of the number of nitrogen atoms or the number of oxygen atoms to the number of carbon atoms in the amorphous carbon film, the oxygen permeability of the film and the amount of elution of aldehyde weremeasured for the PET bottle 10 obtained by the present example in a manner identical to example 6. The results are shown in Table 2, together with the oxygen transmission rate per bottle per day.

### [Comparative Example 4]

According to the present comparative example, a 350 ml PET bottle 10 having an amorphous carbon film with a thickness of 0.006 µm (60 angstrom) coated on the inner surface was formed under the exact same conditions as example 6, except that the flow rate of material gas containing acetylene gas was suppressed to a low value compared to that of example 6.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

### [Comparative Example 5]

According to the present comparative example, a 350 ml PET bottle 10 having no amorphous carbon film coated thereon was subjected to measurement of the amount of elution of aldehyde under the exact same conditions as example 6. The results are shown in Table 2, together with the oxygen transmission rate per bottle per day.

### [Comparative Example 6]

According to the present comparative example, a 350 ml PET bottle 10 having an amorphous carbon film with a thickness of 0.045 µm (450 angstrom) coated on the inner surface was formed under the exact same conditions as example 6, except that a mixed gas containing acetylene gas as material gas and a small amount of oxygen gas was used.

Next, the ratio of the number of nitrogen atoms or the number of oxygen atoms to the number of carbon atoms in the amorphous carbon film, the oxygen permeability of the film and the amount of elution of aldehyde were measured for the PET bottle 10 obtained by the present example in a manner identical to example 6. The results are shown in Table 2, together with the oxygen transmission rate per bottle per day.

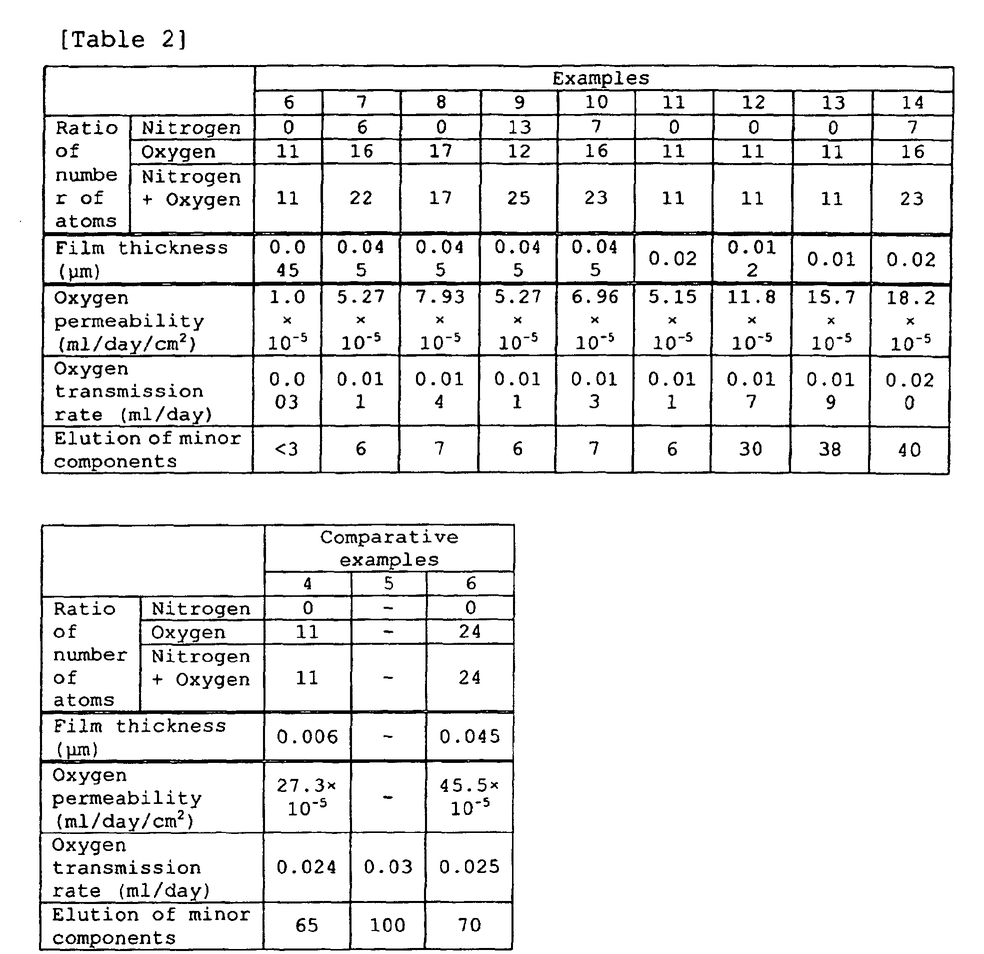

- Ratio of number of atoms:: Ratio of number of atoms of each element when the number of carbon atoms contained in the film is 100
"Nitrogen + Oxygen" shows total number of nitrogen and oxygen atoms
- Elution of minor components:: Relative value to a bottle having no amorphous carbon film coated thereon, when the value of the bottle having no amorphous carbon film is 100

As shown in Table 2, the PET bottles 10 of examples 6 through 14 all have an amorphous carbon film whose oxygen permeability is 20×10⁻⁵ ml/day/cm² or less and have an oxygen transmission rate per bottle per day of 0.02 ml or less, so it is clear that they have superior gas barrier properties.

Furthermore, the PET bottles 10 of examples 6 through 14 all measured an amount of elusion of minor components taking aldehyde as index that is 50 % or lower to that of the PET bottle 10 of comparative example 5 having no amorphous carbon coating, so it is clear that they have superior properties to suppress elution of minor components.

The PET bottles 10 of comparative examples 1 and 3 all have an oxygen permeability greater than 20×10⁻⁵ ml/day/cm² with respect to the above-mentioned examples 6 through 14, so it is clear that they do not have sufficient properties to suppress elution of minor components.

Next, the PET bottles 10 according to examples 6 through 14 were filled with tea beverage, which were kept at room temperature for six months, and then subjected to content evaluation. As a result, there were very little change in color of the contents, and no change in flavor.

Further, the PET bottles 10 of examples 6 through 14 were filled with carbonated beverage, which were kept at room temperature for six months, and then subjected to content evaluation. As a result, there were very little change in gas volume, and the result was good.

Next, the PET bottles 10 of examples 6 through 14 were each crushed to form regenerated polyethylene terephthalate resin chips using an extruding machine, which showed very little coloring. Thereafter, the chips were used to manufacture polyester fibers, which were fabricated without any practical problems. Accordingly, it is clear that the PET bottles 10 of examples 6 through 14 each have equivalent reusability as the PET bottle having no amorphous carbon film coated thereon.

### Industrial Applicability

The plastic container with a coated inner surface and the method for manufacturing the same according to the present invention can be applied to a container for storing fluid materials such as beverage, food, aerosol or medicine, which can be collected after use and recycled.

## Claims

1. A plastic container with a coated inner surface having an amorphous carbon film formed by plasma CVD from a starting material containing carbon atoms and containing carbon as a main component on the inner surface, wherein
when the number of carbon atoms contained in the film is 100, the amorphous carbon film characterizes in that:
a ratio of the number of nitrogen atoms to the number of carbon atoms is 15 or less; or
a ratio of the number of oxygen atoms to the number of carbon atoms is 20 or less; or
a ratio of the total number of nitrogen atoms and oxygen atoms to the number of carbon atoms is 27 or less; or
the ratio of the number of nitrogen atoms to the number of carbon atoms is 15 or less, the ratio of the number of oxygen atoms to the number of carbon atoms is 20 or less, and the ratio of the total number of nitrogen atoms and oxygen atoms to the number of carbon atoms is 27 or less.

2. The plastic container with a coated inner surface according to claim 1, wherein the plastic container is formed of a polyester resin.

3. The plastic container with a coated inner surface according to claim 1, wherein the plastic container is formed of a polyolefin resin.

4. The plastic container with a coated inner surface according to claims 2 or 3, wherein the amorphous carbon film has a thickness within the range of 0.02 through 0.08 µm.

5. The plastic container with a coated inner surface according to claim 1, wherein the amorphous carbon film has an oxygen permeability of 20×10⁻⁵ ml/day/cm² or less.

6. The plastic container with a coated inner surface according to claim 5, wherein the amorphous carbon film has a thickness within the range of 0.007 through 0.08 µm.

7. The plastic container with a coated inner surface according to claims 5 or 6, wherein the plastic container is formed of a polyester resin, and has a body portion having a thickness within the range of 0.2 through 0.5 mm.

8. The plastic container with a coated inner surface according to any one of claims 5 through 8, wherein the plastic container has an inner volume of 2000 ml or less.

9. The plastic container with a coated inner surface according to any one of claims 1 through 8, wherein the starting material contains acetylene as a main component.

10. A method for manufacturing a plastic container with a coated inner surface comprising the steps of placing the plastic container in a plasma CVD apparatus, maintaining an interior of the plasma CVD apparatus to a predetermined vacuum degree, feeding a gaseous starting material including carbon atoms into the plastic container, supplying a predetermined energy into the plasma CVD apparatus to generate plasma within the plastic container thereby forming an amorphous carbon film containing carbon as a main component on the inner surface of the plastic container, wherein
gas components containing the starting material fed into the plastic container comprises:
a nitrogen gas whose amount being mixed is 20 % by volume or less to the total amount of the gas components; or
an oxygen gas whose amount being mixed is 10 % by volume or less to the total amount of the gas components; or
an oxygen gas whose amount being mixed is 10 % by volume or less to the total amount of the gas components, and the total amount of nitrogen gas and oxygen gas being mixed is 15 % by volume or less.

11. The method for manufacturing a plastic container with a coated inner surface according to claim 10, comprising the steps of detecting an emission intensity of plasma of nitrogen based on an emission spectrum of the plasma generated by the gas components containing the starting material being fed into the plastic container, and controlling a concentration of a nitrogen containing compound being mixed into the gas components.

12. The method for manufacturing a plastic container with a coated inner surface according to claim 10, comprising the steps ofdetecting an emission intensity of plasma of nitrogen based on an emission spectrum of the plasma generated from the gas components containing the starting material being fed into the plastic container, and controlling an amount of air being mixed into the gas components.

13. The method for manufacturing a plastic container with a coated inner surface according to claims 11 or 12, wherein when the emission intensity of plasma of nitrogen exceeds a predetermined intensity, the plastic container having the amorphous carbon film coated thereon is eliminated from the manufacturing process.

14. The method for manufacturing a plastic container with a coated inner surface according to any one of claims 11 through 13, wherein the detection of emission intensity of plasma of nitrogen is carried out by selectively detecting the emission of a specific wavelength range in the emission spectrum.

15. The method for manufacturing a plastic container with a coated inner surface according to any one of claims 10 through 14, wherein the plastic container with the coated inner surface is formed of a polyester resin.

16. The method for manufacturing a plastic container with a coated inner surface according to any one of claims 10 through 14, wherein the plastic container with the coated inner surface is formed of a polyolefin resin.

17. The method for manufacturing a plastic container with a coated inner surface according to any one of claims 10 through 16, wherein the film has a thickness within the range of 0.02 through 0.08 µm.

18. The method for manufacturing a plastic container with a coated inner surface according to any one of claims 10 through 17, wherein the starting material is substantially composed of acetylene.

19. The method for manufacturing a plastic container with a coated inner surface according to any one of claims 10 through 18, comprising the steps of:
decompressing the plasma CVD apparatus and maintaining the interior of the plastic container placed in the apparatus to a vacuum degree of 1 through 50 Pa;
feeding the starting material in a form of gas containing the carbon atoms into the plastic container within the range of 0.1 through 0.8 sccm/cm² with respect to an inner surface area of the plastic container;
radiating microwaves with energy within the range of 150 through 600 W into the plasma CVD apparatus; and
generating plasma in the plastic container for a period of time within the range of 0.2 through 2.0 seconds, thereby forming the amorphous carbon film on the inner surface of the plastic container.

20. The method for manufacturing a plastic container with a coated inner surface according to claim 19, wherein if the plastic container with the coated inner surface is a container having no self-shape holding property, the interior of the container placed in the plasma CVD apparatus is maintained at higher pressure than the exterior thereof.
